# EUROPEAN PATENT APPLICATION

(11) **EP 3 879 950 A1**
(43) Date of publication of application: **15.09.2021**
(21) Application number: 20162451.7
(22) Date of filing: 11.03.2020
(51) Int. Cl.: H05K 7/20

(54) **AIR CONDITIONING OF A DATA CENTRE**

(71) Applicant: ABB Schweiz AG, 5400 Baden (CH)
(72) Inventor: ZHANG, Xiaojing, 722 10 Västerås (SE)
(74) Representative: Kransell & Wennborg KB

(57) **Abstract**

The invention is concerned with a method, system and computer program product for controlling air conditioning in an area (10) of a data centre. The system comprises a mapping unit (18A) that obtains temperature measurements from a number of sensors (14A-M) placed at different positions in the area (10), where the measurements are obtained for different settings of air conditioning equipment (12A, 12B, 12C, 12D) surrounding the area (10), that obtains a number of computational fluid dynamics simulations comprising air flow and temperature distribution patterns in the whole area (10) of the data centre for the same air conditioning equipment settings and that updates the computational fluid dynamics simulations based on the actual temperature measurements. The system also comprises an air condition control unit (18B) that controls the air condition equipment (12A, 12B, 12C, 12D) to regulate temperature and air flow in the area using the updated computational fluid dynamics simulations.

## Description

### FIELD OF THE INVENTION

The present invention relates to a method, system and computer program product for of controlling air conditioning in a data centre.

### BACKGROUND

Air conditioning of a data centre may be problematic. Different servers may have different loads with a consequential difference in temperatures in the data centre. This is often hard to handle in an efficient way. For this reason it may be of interest to use Computational Fluid Dynamics (CFD) in the air conditioning.

CFD represents numerical approaches to fluid mechanics that can be used to predict the, velocity and temperature fields. CFDs have previously been used in relation to data centres.

US 2016/0234972 discloses a cooling optimization method for a data centre based on measured and calculated data as well as on a CFD model. An optimization solver in turn determines optimal cooling set point values for the data centre.

US 2011/0016342 discloses a method for power analysis for a plurality of computing platform components comprising receiving information associated with a component, retrieving, using a computer processor, electronically stored data associated with the component, estimating power usage of the component based at least in part on the stored data, and outputting an indicator of power usage. In the method a CFD model is also used.

US 2015/0363515 discloses a method of capturing a plurality of design and operational parameters of a data centre, computing an efficient design for the data centre at full occupancy, and maintaining a Power Usage Effectiveness constant or within narrow range around efficient level at a current occupancy during a ramp up period of the data centre for efficiently configuring the data centre. A CFD model is used to assess the effectiveness of different data centre configurations.

CFDs may need too long a time for simulation and are therefore at times too slow and thus difficult to be used for online air conditioning.

There is therefore a need for air conditioning control where CFDs can be used in a more effective way.

### SUMMARY OF THE INVENTION

The present invention addresses this situation. The invention therefore aims at solving the problem of providing air conditioning, where computational fluid dynamics can be used in a more effective way.

This object is according to a first aspect of the invention solved through a method of controlling air conditioning in a data centre having an area being air conditioned by a number of pieces of air conditioning equipment, the area also comprising a number of sensors configured to sense temperatures at different positions in the area, the method comprising the steps of:
- obtaining actual temperature measurements from the sensor positions in the area, said actual temperature measurements being obtained for different settings of the air conditioning equipment,
- obtaining, a number of computational fluid dynamics simulations comprising air flow and temperature distribution patterns in the whole area of the data centre for the same air conditioning equipment settings,
- update the computational fluid dynamics simulations based on the actual temperature measurements, and
- controlling the air conditioning equipment to regulate temperature and air flow in the area using the updated computational fluid dynamics simulations.

The object is according to a second aspect of the invention solved through a system for controlling air conditioning in an area of a data centre, the system comprising a mapping unit and an air condition control unit,
the mapping unit being configured to:
- obtain actual temperature measurements from a number of sensors placed at different positions in the area, the actual temperature measurements being obtained for different settings of air conditioning equipment that surround the area,
- obtain a number of computational fluid dynamics simulations comprising air flow and temperature distribution patterns in the whole area of the data centre for the same air conditioning equipment settings, and
- update the computational fluid dynamics simulations based on the actual temperature measurements, and
the air conditioning control unit being configured to control the air condition equipment to regulate temperature and air flow in the area using the updated computational fluid dynamics simulations.

The object is according to a third aspect achieved through an air conditioning control device comprising a mapping unit and an air condition control unit,
the mapping unit being configured to:
- obtain actual temperature measurements from a number of sensors placed at different positions in the area, the actual temperature measurements being obtained for different settings of air conditioning equipment that surround the area,
- obtain a number of computational fluid dynamics simulations comprising air flow and temperature distribution patterns in the whole area of the data centre for the same air conditioning equipment settings, and
- update the computational fluid dynamics simulations based on the actual temperature measurements, and
the air conditioning control unit being configured to control the air condition equipment to regulate temperature and air flow in the area using the updated computational fluid dynamics simulations

The object is according to a fourth aspect achieved through a computer program product for controlling air conditioning in an area of a data centre, the computer program product being provided on a data carrier comprising computer program code configured to cause an air conditioning system to, when said computer program code is loaded into at least one computer
- obtain actual temperature measurements from a number of sensors placed at different positions in the area, the actual temperature measurements being obtained for different settings of air conditioning equipment that surround the area,
- obtain a number of computational fluid dynamics simulations comprising air flow and temperature distribution patterns in the whole area of the data centre for the same air conditioning equipment settings,
- update the computational fluid dynamics simulations based on the actual temperature measurements, and
- control the air condition equipment to regulate temperature and air flow in the area using the updated computational fluid dynamics simulations.

The obtaining of computational fluid dynamics simulations may involve generating computational fluid dynamics simulations in the area using different settings of the air conditioning equipment. As an alternative the obtaining may comprise retrieving already generated computational fluid dynamics simulations from a database.

The updating of the computational fluid dynamics simulations may comprise calibrating the updated computational fluid dynamics simulations using the actual temperature measurements.

Before performing calibration, it is additionally possible to extract a temperature of a computational fluid dynamics simulation corresponding to an actual temperature measurement, compare the extracted temperature with the actual temperature measurement and calibrate the computational fluid dynamics simulation based on the comparison.

The computational fluid dynamics simulations may be made using a model of the area and the calibration may be made through tuning of the model.

The sensors may have a working or operational sensor range, while the temperatures of the computational fluid dynamics simulations may be provided in a temperature range that is wider than and covers the operational sensor range.

The updating may additionally comprise performing new computational fluid dynamics simulations after the calibration for air conditioning equipment settings leading to temperatures outside of the operational range of the sensors.

The area may also be divided into a number of zones. The controlling of the air conditioning equipment may therefore comprise controlling the air conditioning equipment with settings that according to the updated computational fluid dynamics simulations adjust the temperatures of the zones to reach corresponding desired operational zone temperatures.

At least some of the zones may additionally comprise sectors. At least one of the sectors may cover a part or a section of a server rack, such as half, a third or a fourth of a server rack or a shelf of a server rack.

According to a variation of the first aspect, the controlling of the air conditioning equipment comprises obtaining the temperatures of the sectors in the area, comparing the temperatures of the sectors with at least one temperature threshold, determining which sectors have reached the temperature threshold, selecting, for a sector that has reached a temperature threshold, air conditioning equipment settings that according to the updated computational fluid dynamics simulations adjust the temperature of the sector in order to achieve a temperature control objective and applying the selected air conditioning equipment settings on the air conditioning equipment.

According to a corresponding variation of the second aspect, the air conditioning control unit when controlling the air conditioning equipment to regulate temperature and air flow in the area is configured to obtain the temperatures of the sectors in the area, compare the temperatures of the sectors with at least one temperature threshold, determine which sectors have reached the temperature threshold, select, for a sector that has reached a temperature threshold, air conditioning equipment settings that according to the updated computational fluid dynamics simulations adjust the temperature of the sector in order to achieve a temperature control objective and apply the selected air conditioning equipment settings on the air conditioning equipment.

The obtained temperature of a sector may be a temperature measured using a sensor in the sector. The temperature may additionally be a temperature derived for a sector based on computational fluid dynamics simulations of another sector in the vicinity, where the deriving may be the extracting of the temperature of the sector from the CFD simulation. One part or section of a rack, such as a top shelf, may for instance be equipped with a sensor and the temperatures of the other sections of the rack, such as the sections below the top section, may be derived from the temperature measured by the sensor and deriving the temperature of the section from the computational fluid dynamics simulation having been made with the current air conditioning equipment settings and current temperature.

Moreover, the control of the air conditioning equipment may comprise a first type of air condition control where the temperatures of the sectors are compared with a hotspot temperature threshold and the control objective is the lowering of the temperature of a sector to a desired operational temperature of the sector. The lowering may in this case compromise a lowering with a maximum speed. The first type of air condition control may therefore be a hotspot air condition control.

The air conditioning control may additionally comprise a second type of air condition control where the temperatures of the sectors are compared with an overcooling temperature threshold and the control objective is the raising of the temperature to a desired operational temperature. The raising may in this case comprise a raising using the least amount of energy, where the energy being minimised this way may be the energy used to power the air conditioning equipment, such as to operate a fan or to control water temperature of a piece of air conditioning equipment. The second type of air condition control may therefore be an overcooling air condition control.

The first type of air condition control may additionally be performed for a first sector and the second type of air condition control may be simultaneously performed for a second sector. In this case it is also possible that there is a compromise in the control objectives for the first and the second sectors.

The system may comprise the air conditioning equipment and the sensors in addition to the mapping unit and air condition control unit.

The mapping unit and air condition control unit may additionally be provided in the same device or in separate devices, where each such device may be an air conditioning control device.

The present invention has a number of advantages. Through the updating of simulations it is possible to limit the number of simulations, which allows the air conditioning control to start faster than if only simulations were used. The simulations may also become more realistic and better resemble actual air flows and temperatures in the area through the combination. Another advantage is that the measurements may be obtained with a limited number of sensors. The use of computational fluid dynamics also enables an improved air conditioning where different zones are cooled differently from each other.

### BRIEF DESCRIPTION OF THE DRAWINGS

The present invention will in the following be described with reference being made to the accompanying drawings, where
Fig. 1 schematically shows an area of a data centre comprising a number of server racks and sensors in different zones, which server racks are cooled by air conditioning equipment under the control of an air conditioning control device that comprises a mapping unit and an air condition control unit,
Fig. 2 shows a flow chart of a number of method steps in a method of controlling air conditioning of the area and being performed by the air conditioning control device,
Fig. 3 schematically shows the generation of a computational fluid dynamics simulation in the area of fig. 1,
Fig-. 4 schematically shows a server rack with server equipment, which server rack comprises sections covered by sectors of the zones in the area,
Fig. 5 shows a number of method steps in an air condition control scheme being performed by the air condition control unit,
Fig. 6 schematically shows a cooling control graph for hotspot cooling,
Fig. 7 schematically shows a cooling control graph for overcooling, and
Fig. 8 schematically shows a data carrier with computer program code, in the form of a CD-ROM disc, for implementing the mapping unit and air condition control unit.

### DETAILED DESCRIPTION OF THE INVENTION

In the following, a detailed description of preferred embodiments of a method, air conditioning system and computer program product for controlling air conditioning in a data centre will be given.

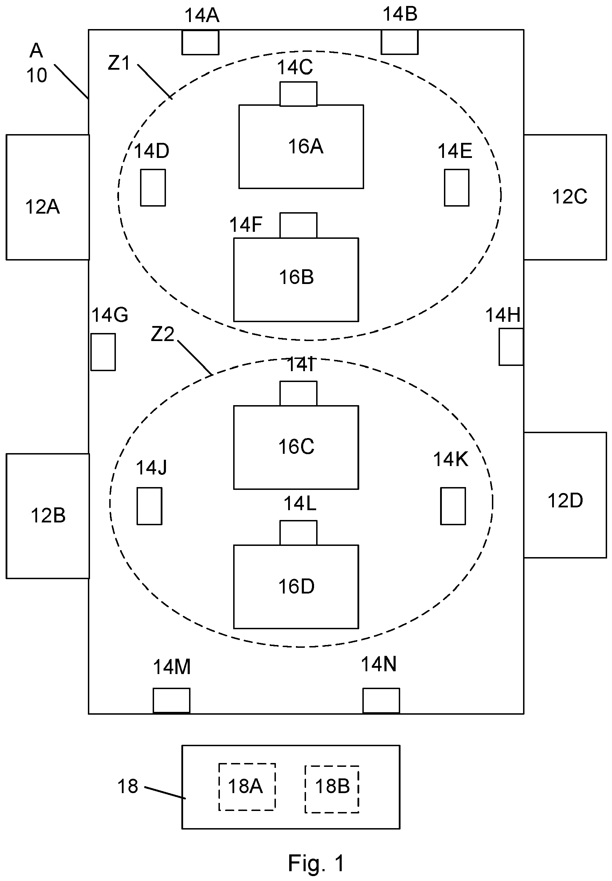

Fig. 1 schematically shows an area A10 of a data centre comprising a number of server racks 16A, 16B, 16C and 16D with server equipment, where the area 10 may be a room in a building. In the area there are also a number of sensors 14A - 14N. The sensors may comprise temperature sensors. However also other types of sensors are possible such as humidity sensors and sensors sensing the power consumption of server equipment. The sensors may additionally be distributed throughout the area 10 and placed in different discrete positions and configured to sense the temperature at these positions. In this respect it is also possible that sensors 14A, 14B, 14G, 14H, 14M and 14N are placed on the walls of the room, that sensors 14C, 14F14I and 14L are placed on the server racks 16A, 16B, 16C and 16D, such as one sensor per server rack, and that sensors 14D, 14E. 14J and 14K are placed at other positions in the area, such as between the air conditioning equipment 12A, 12B, 12C and 12D and the server racks 16A, 16B 16C and 16D. The sensor positions may be selected based on computational fluid dynamics (CFD) simulations that have been made in order to obtain general air flow and temperature distribution patterns as well as based on the location of server equipment that likely will need cooling. The area 10 also comprises or is made up of a number air conditioning zones, each covering a certain part of the room, like half, a quarter or an eighth of the area or a group of server racks, where a group of server racks may comprise varying number of racks, such as two or three or even twenty racks. As an example, there is here a first zone Z1 covering a first and a second server rack 16A and 16B and a second zone Z2 covering a third and a fourth server rack 16C and 16D.

Around the area 10 there is also air conditioning equipment, 12A, 12B, 12C and 12D. The pieces of air conditioning equipment 12A, 12B, 12C and 12D thus surround the area 10 and are provided for the air conditioning of it. As an example, four pieces of air conditioning equipment 12A, 12B, 12C and 12D are shown outside two opposing walls of the room. It should here realized that more or fewer pieces of air conditioning equipment may be used. It should also be realized that there may be more or fewer racks. As an example, it is for instance possible that four pieces of air conditioning equipment are used for air conditioning at least ten racks. As another example six or more pieces of air-conditioning equipment may be used for air conditioning thirty or more racks in an area that is divided into serval zones. It should also be realized that there be may be more or fewer sensors. The air conditioning equipment may additionally comprise one or more Computer Room Air Conditioners (CRAC) and/or one or more Computer Room Air Handlers (CRAH). A piece of air conditioning equipment may be configured to blow or draw cooled or heated and possibly humidified hair into and out from the area 10.

The area 10 shown in fig. 1 is two-dimensional. However, the area is typically a three-dimensional volume. It should therefore be realized that sensors may also be placed in a third non-disclosed dimension.

There is also an air conditioning control device 18 comprising a mapping unit 18A and an air condition control unit 18B. The air conditioning control device 18 may be realized as one or more computers with computer program code implementing the functionality of the mapping unit 18A and the air condition control unit 18B.

The mapping unit 18A and air condition control unit 18B may together for a system for controlling air conditioning in the data centre. It is possible that also the sensors and air conditioning equipment belong to the system.

In a typical existing mid-size data centre, IT, cooling and power facilities from different manufactures are installed without coordination. There are limited sensors to measure temperatures, humidity and facility power consumptions. Because of reliability and security requirement, data centres do not allow to perform any tests to investigate optimal operation strategies. It may therefore be difficult to understand operation status in details and realize which server equipment that needs cooling and which that does not. Moreover, the amount of information that can be obtained from the sensors, the number of temperature sensors, their temperature ranges and the number of sensor locations are limited. This also puts limitations on the efficiency of the air conditioning.

Aspects of the invention are concerned with controlling the air conditioning of the area in a data centre as exemplified by the area 10 shown in fig. 1.

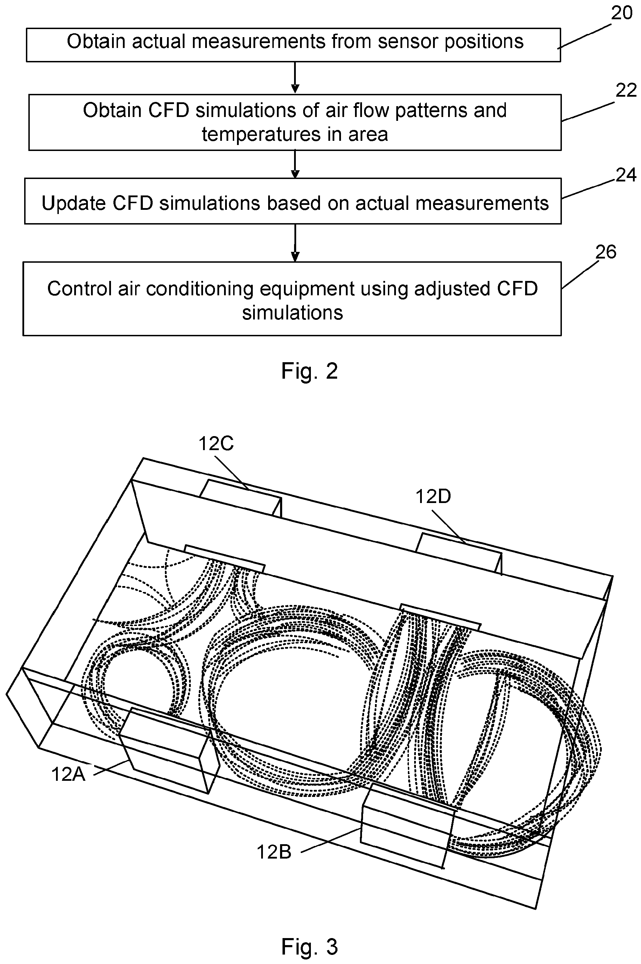

How this may be done will now be described with reference being made also to fig. 2, which shows a number of steps in a flow chart depicting a scheme for controlling air conditioning in the area 10, which scheme is being performed by the air conditioning control device 18. The first three steps of the scheme are being performed by the mapping unit 18A off-line, i.e. before any air conditioning takes place in the area 10, while the last step is performed by the air condition control unit 18B on-line, i.e. when the data centre is operational and the air conditioning equipment 12A, 12B, 12C and 12D is running.

The method is started by the mapping unit 18A obtaining actual temperature measurements from the sensors at the different sensor positions in the area, step 20, where the sensor measurements are obtained for or at different settings of the air conditioning equipment 12A, 12B, 12C and 12D. It is here possible that the measurements are being obtained for every possible setting combination of the equipment and that a set of measurements is being stored for each such equipment setting combination. An equipment setting combination may in this case be a certain setting of all the parameters of all the air conditioning equipment. The totality of equipment setting combinations are then all possible parameter setting combinations. The measurements may also have a time dependency. There may thus be temperature measurements obtained in a transient phase when new equipment setting combinations have just been applied as well as measurements made during a time for the temperature to settle in.

The mapping unit 18A also obtains CFD simulations comprising air flow and temperature distribution patterns in the whole area, step 22, which may be done through simulating these patterns using CFD technology. They may be obtained through generating CFD simulations in the area using the same settings of the air conditioning equipment. The simulations are then made for the same combinations of equipment settings, i.e. for the same air conditioning equipment settings, as those for which actual measurements were obtained. How such a simulation may be made is as such known and is also schematically shown in fig. 3. The example in fig. 3 shows a CFD simulation representing an air flow pattern under raised floor to see which air conditioning equipment has more or less cooling impact to which server rack. Such a simulation also comprises a temperature distribution, which temperature distribution is typically visualized using different colours in the air flows (not shown). The shown CFD simulation is merely one example and other types of air flow simulations may also be used, such as simulations of air flow patterns over the floor.

As an alternative the obtaining may comprise retrieving already generated computational fluid dynamics simulations from a database.

The temperatures of the simulations are then the temperatures in the whole of the area 10, i.e. not only in the discrete sensor positions. As was mentioned earlier, the sensor measurements may also comprise other types of measurements than temperature, such as humidity, fan speed and power consumption.

The mapping unit 18A may for this reason comprise a Parameterized CFD simulation tool used to simulate data centre air flow, temperature, humidity distributions and flow patterns in order to generate simulated data. This CFD tool is also able to simulate air flow pattern and temperature distribution in air plenum and identify correlations among each piece of air conditioning equipment and sections of individual server rack with a degree of influence. The CFD simulations thus provide air flow and temperature distribution patterns that identify the relationship among each piece of air conditioning equipment and the individual server racks. Since CFD will take a long time to generate results, the CFD simulations should be pre-run to represent several operation scenarios.

For a specified data centre, pre-run CFD simulations can generate a large amount of operational data to compensate shortage of the real sensor measurements.

The mapping unit 18A then updates the CFD simulations based on the actual measurements, step 24. This may involve applying the measurements of a certain equipment setting combination on the CFD simulation made for the same equipment setting combination.

The updating of the CFD simulations may comprise calibrating the obtained CFD simulations using the actual temperature measurements.

Before performing calibration, it is additionally possible to extract a temperature of a CFD simulation corresponding to an actual temperature measurement, compare the extracted temperature with the actual temperature measurement and calibrate the CFD simulation based on the comparison. The calibration may more particularly be based on the difference, where the CFD simulation that corresponds to the actual temperature measurement again is the simulation that has been made for the same air conditioning equipment settings.

The CFD simulation tool may have a model of the temperature variation and air flow in the area and the calibration may involve tuning the model.

It is finally possible to perform new CFD simulations after the calibration using various air conditioning settings. These new CFD simulations may be made for temperatures outside of the operational sensor range. The temperature range of the simulations may thus be wider than and cover the operational temperature range of the sensors.

The performing of simulations anew may, because they are based on the calibration using the measured temperatures, improve also the simulations where temperatures are outside of the working ranges of the sensors.

The sensor measurements have their limitation in narrow operational or working ranges, for example, rack supply air temperature is normally between 18 to 27 degrees, however, CFD simulation can get data in much wide ranges. They do therefore complement each other.

The updated CFD simulations provide data that can be used for implementing optimal dynamic air conditioning strategies.

Through the updating it is possible to limit the number of simulations, which allows the on-line air conditioning to start faster than if only simulations were used. The simulations may also become more realistic and better resemble actual air flows and temperatures in the area through the combination. Another advantage is that the measurements may be obtained with a limited number of sensors. It is thus possible to limit the number of sensors used in the area both in order to be combined with CFD simulations as well as during the air conditioning. It is for instance possible that sensors used in the on-line air conditioning are only placed at positions where cooling is expected to be needed, for instance close to server equipment where processing is implemented.

The updated CFD simulations are thereafter used in the air conditioning control.

After the CFD simulations have been updated, the air condition control unit 18B therefore controls the air conditioning equipment 12A, 12B, 12C and 12D to regulate temperature and air flow in the area using the updated CFD simulations, step 26.

The controlling of the air conditioning equipment may more particularly comprise separately controlling the temperatures of different zones in the area. Each zone may then have at least one temperature sensor. The air conditioning equipment may then be controlled so that the actual temperature of the zone is to meet a desired control temperature, which control is then based on the updated CFD simulations.

The actual zone temperature may be sensor temperature or a combination of the sensor temperatures in the zone. Alternatively, the actual zone temperature may be derived from a CFD simulation corresponding to one or more sensor temperatures in the zone.

The control may then involve selecting a CFD that achieves a desired zone temperature and then controlling the air conditioning equipment using the air conditioning equipment settings associated with this CFD.

With the zone definition and CFD flow simulations, it is then possible to know which piece of air conditioning equipment or which combination of air conditioning equipment is to control which zone(s).

Different server racks may be heated differently because of load differences. With the above described control it is possible to control the zones separately and thus to provide different cooling for different zones and consequently also to provide separate cooling of different racks.. However, servers may also have load variations within a rack. It may be of interest to also handle these situations.

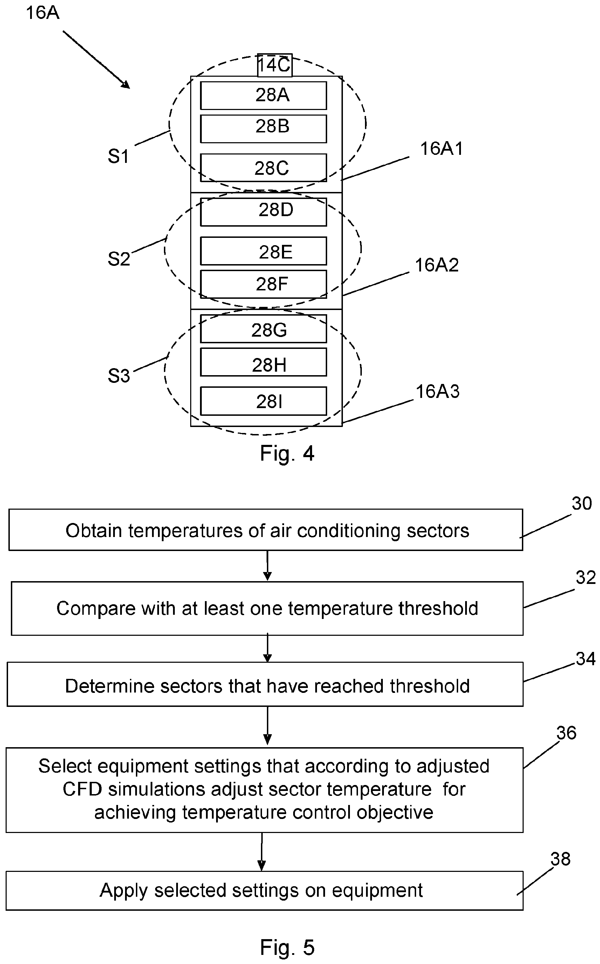

It is for this reason possible to have a finer division of the area. Therefore, at least some of the zones may comprise sectors, where a sector may cover a section of a server rack. In some aspects a sector may thus cover a section of a server rack where server equipment is placed, such as half, a third or a fourth of a server rack or a server rack shelf. As an example shown in fig. 4, a first sector Si of the first zone Z1 may cover a first section 16A1 of the first server rack 16A comprising server equipment 28A, 28B and 28C, a second sector S2 may cover a second section 16A2 of the server rack 16A comprising server equipment 28D, 28E and 28F, while a third sector S3 may cover a third section 16A3 of the server rack 16A comprising server equipment 28G, 28H and 28I. When sectors cover sections of a server rack, the sectors may be vertically displaced from each other. However, in some case they may also be horizontally separated from each other. A sensor may more particularly be placed on top of a server rack, which means that it is possible that it is actually not inside any sector covering a rack section.

How the implementation of this type of air conditioning may generally be carried out will now be described in some more detail with reference being made to the flow chart in fig. 5.

The air condition control unit 18B obtains temperatures of sectors in the area 10, step 30 An obtained temperature maybe an actual measured temperature of the sector. However, sectors may rarely comprise sensors. As an alternative the obtained temperature may therefore be a temperature derived for a sector based on computational fluid dynamics simulations of a sensor in the vicinity of the sector, for instance in another sector. This other sector may be a sector covering another section of the same rack. One section of a rack may be equipped with a sensor and the temperatures of the other sections of the rack, may then be derived from the measured temperature of the section with the sensor and CFD simulations with current air conditioning equipment settings.

As an alternative, the sensor may be placed outside of the rack sections. It may thus be placed outside of all sectors that cover racks.

In the rack example in fig. 4, a sensor 14C is placed above the top section 16A1 in the first sector Si at the top of the stack. Also, the lower sections 16A2 and 16A3 in the second and third sectors S1 and S2 below the top section lack sensors. In this case the temperatures of the sectors are derived from the temperature of the sensor 14C and CFD simulations made using the current air conditioning equipment settings.

The obtained temperatures are then compared with at least one temperature threshold, step 32, where a temperature threshold may as an example be a hotspot temperature threshold or an overcooling temperature threshold.

For a threshold, the air conditioning control unit 18B then determines which sectors that have reached the temperature threshold, step 34, and thereafter select air conditioning equipment settings that according to the updated CFD simulations adjust the sector temperature for achieving a temperature control objective, step 36. The temperature control objective may in this case be to control the sector temperature to reach a desired operational sector temperature. It may additionally be to reach the temperature as fast as possible or to change the temperature using as little energy as possible, where the energy that is to be minimized may be the energy required for operating the air conditioning equipment.

After the equipment settings have been selected based on the updated CFD simulations, the air condition control unit 18B then applies the selected air conditioning equipment settings on the air conditioning equipment 12A, 12B, 12C and 12D, step 38, which may be done through controlling the air conditioning equipment 12A, 12B, 12C and 12D according to the selected settings.

It can thereby be seen that the control is made based on the updated CFD simulations and thereby it is possible to implement a fine temperature control on an individual sector level.

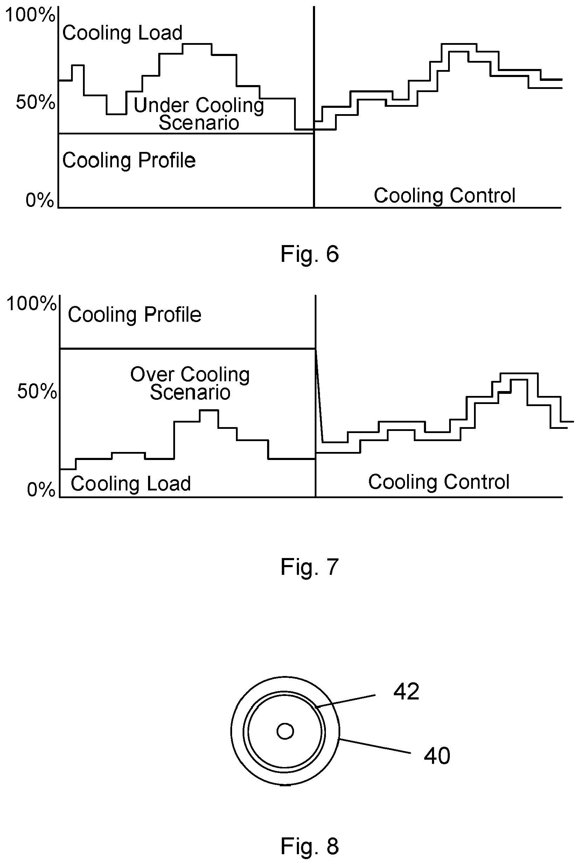

As was mentioned above, the control may be the control of hotspots, which is a first type of air condition control where the temperature of the sector is compared with a hotspot temperature threshold and the control objective is the lowering of the temperature of a sector to the desired operational temperature. Hotspot cooling is generally shown in fig. 6. If a sector is found to reach a hotspot threshold, then the control can be made so that a desired temperature level is reached. The settings may then be the settings that according to the CDF simulations reach the desired temperature in the fastest way possible. It may thus be a lowering with a maximum speed. This may be a setting which according to the updated CFD simulations directs the strongest possible air flow with the lowest possible temperature towards the sector.

As an alternative the control may be the control of overcooling, which is a second type of air condition control where the temperature of the sector is compared with an overcooling temperature threshold and the control objective is the raising of the temperature of a sector to the desired operational temperature. Overcooling control is generally shown in fig. 7. In this case the control may be a control that reaches the desired operational temperature with the least amount of energy, such as the energy used to operate a fan or to control water temperature of a piece of air conditioning equipment.

As can be seen in both types of control it is possible to adaptively change the control for each change in temperature in order to make the sector reach the desired temperature.

The two types of control may additionally be performed simultaneously. The first type of air condition control may thus be performed for a first sector and the second type of air condition control may be simultaneously performed for a second sector. It is thereby possible for one sector to be controlled for avoiding becoming a hotspot, while another sector is controlled for avoiding overcooling. When this is done a compromise may be required between the two control objectives. The speed with which a hot spot is cooled to a desired temperature may thus be decreased from the ideal case, while an overcooling may be avoided using a higher amount of energy than what is required in the ideal case.

Thereby air conditioning that is made in different sectors, which may be on a server rack section level, can be implemented. The air conditioning can be because of this be made more energy-efficient.

As was mentioned earlier, the air conditioning control device may be realized as a processor acting on program instructions, for instance stored in a program memory, where the program instructions implement the mapping unit and air condition control unit. The device may in such a case be implemented as an integrated circuit such as an Application Specific Integrated Circuit (ASIC) or a Field-Programmable Gate-Array (FPGA). The air conditioning control device may also be realized as a computer comprising the processor and program memory. If the air conditioning control device comprises a memory, the CFD simulations may be stored in this memory. They may as an alternative be stored in a separate database.

Above the mapping unit and air condition control unit were provided in the same air conditioning control device. As an alternative to providing the two units in the same device, they may additionally be provided in separate devices, e.g. in different air conditioning control devices.

As can be seen above, the mapping unit and the air condition control unit may be implemented using software. They may thus be implemented using computer program code, which may be provided on one or more data carriers which performs the functionality of these units when the program code thereon is being loaded into one or more computers implementing the air conditioning control device. One such data carrier 40 with computer program code 42, in the form of a CD ROM disc, is schematically shown in fig. 8. Such computer program may as an alternative be provided on a server and downloaded therefrom into the one or more computer.

## Claims

1. A method of controlling air conditioning in a data centre having an area (10) being air conditioned by a number of pieces of air conditioning equipment (12A, 12B, 12C, 12D), said area (10) also comprising a number of sensors (14A - M) configured to sense temperatures at different positions in the area (10), the method comprising the steps of:
- obtaining (20) actual temperature measurements from the sensor positions in the area, said actual temperature measurements being obtained for different settings of the air conditioning equipment (12A 12B, 12C, 12D),
- obtaining (22), a number of computational fluid dynamics simulations comprising air flow and temperature distribution patterns in the whole area (10) of the data centre for the same air conditioning equipment settings,
- updating (24) the computational fluid dynamics simulations based on the actual temperature measurements, and
- controlling (26) the air conditioning equipment (12A, 12B, 12C, 12D) to regulate temperature and air flow in the area using the updated computational fluid dynamics simulations.

2. The method according to claim 1, wherein the sensors have an operational sensor range, while the temperatures of the computational fluid dynamics simulations are provided in a temperature range that is wider than and covers the operational sensor range.

3. The method according to claim 1 or 2, wherein the area comprises a number of zones (Z1, Z2) and the controlling of the air condition equipment comprises controlling the air conditioning equipment with settings that according to the updated computational fluid dynamics simulations adjust the temperatures of the zones to reach corresponding desired operational zone temperatures.

4. The method according to any previous claim, wherein at least some zones (Z1) comprise sectors (S1, S2, S3) and the controlling of the air conditioning equipment comprises obtaining (30) the temperatures of sectors (S1, S2, S3) in the area (10), comparing (32) the temperatures of the sectors (S1, S2, S3) with at least one temperature threshold, determining (34) which sectors have reached the temperature threshold, selecting (36), for a sector that has reached a temperature threshold, air conditioning equipment settings that according to the updated computational fluid dynamics simulations adjust the temperature of the sector in order to achieve a temperature control objective and applying (38) the selected air conditioning equipment settings on the air conditioning equipment (12A, 12B, 12C,12D).

5. The method according to claim 4, wherein at least one sector (Si, S2, S3) covers a section of a server rack (16A).

6. The method according to claim 4 or 5, wherein the control of the air conditioning equipment comprises a first type of air condition control where the temperatures of the sectors are compared with a hotspot temperature threshold and the control objective is the lowering of the temperature of a sector to a desired operational temperature.

7. The method according to claim 6, wherein the lowering compromises a lowering with a maximum speed.

8. The method according to any of claims 4 - 7, wherein the air conditioning control comprises a second type of air condition control where the temperatures of the sectors are compared with an overcooling temperature threshold and the control objective is the raising of the temperature to a desired operational temperature.

9. The method according to claim 8, wherein the raising comprises a raising using the least amount of energy.

10. The method according to claim 8 or 9 when depending on claim 6, wherein the first type of air condition control is performed for a first sector and the second type of air condition control is simultaneously performed for a second sector.

11. A system for controlling air conditioning in an area (10) of a data centre, the system comprising a mapping unit (18A) and an air condition control unit (18B),
the mapping unit (18A) being configured to:
- obtain actual temperature measurements from a number of sensors (14AN) placed at different positions in the area (10), said actual temperature measurements being obtained for different settings of air conditioning equipment (12A, 12B, 12C, 12D) that surround the area (10),
- obtain a number of computational fluid dynamics simulations comprising air flow and temperature distribution patterns in the whole area (10) of the data centre for the same air conditioning equipment settings, and
- update the computational fluid dynamics simulations based on the actual temperature measurements, and
the air conditioning control unit (18B) being configured to control the air condition equipment (12A, 12B, 12C, 12D) to regulate temperature and air flow in the area using the updated computational fluid dynamics simulations.

12. The system according to claim 11, wherein the area comprises a number of zones (Z1, Z2) and the air conditioning control unit (18B) when controlling the air conditioning equipment (12A, 12B, 12C, 12D) to regulate temperature and air flow in the area (10) is configured to control the air conditioning equipment with settings that according to the updated computational fluid dynamics simulations adjust the temperatures of the zones (Z1, Z2) to reach corresponding desired operational zone temperatures.

13. The system according to any of claims 11 - 13, wherein the area comprises a number of zones (Z1, Z2) and the air conditioning control unit (18B) when controlling the air conditioning equipment (12A, 12B, 12C, 12D) to regulate temperature and air flow in the area (10) is configured to obtain the temperatures of sectors (Si, S2, S3) in the area, compare the temperatures of the sectors (S1, S2, S3) with at least one temperature threshold, determine which sectors have reached the temperature threshold, select, for a sector that has reached a temperature threshold, air conditioning equipment settings that according to the updated computational fluid dynamics simulations adjust the temperature of the sector in order to achieve a temperature control objective and apply the selected air conditioning equipment settings on the air conditioning equipment (12A, 12B, 12C, 12D).

14. The system according to claim 13, wherein the air condition control unit (18B) is configured to perform a first type of hotspot air condition control for a first sector and simultaneously perform the second type of overcooling air condition control for a second sector.

15. A computer program product for controlling air conditioning in an area (10) of a data centre, said computer program product being provided on a data carrier (40) comprising computer program code (42) configured to cause an air conditioning system to, when said computer program code is loaded into at least one computer
- obtain actual temperature measurements from a number of sensors (14A-M) placed at different positions in the area (10), said actual temperature measurements being obtained for different settings of air conditioning equipment (12A, 12B, 12C, 12D) that surround the area (10),
- obtain a number of computational fluid dynamics simulations comprising air flow and temperature distribution patterns in the whole area (10) of the data centre for the same air conditioning equipment settings,
- update the computational fluid dynamics simulations based on the actual temperature measurements, and
- control the air condition equipment (12A, 12B, 12C, 12D) to regulate temperature and air flow in the area using the updated computational fluid dynamics simulations.
